# EUROPEAN PATENT APPLICATION

(11) **EP 1 035 549 A1**
(43) Date of publication of application: **13.09.2000**
(21) Application number: 99944791.5
(22) Date of filing: 22.09.1999
(51) Int. Cl.: G11C 11/14, H04L 9/00

(54) **CIPHER MACHINE**

(30) Priority: 30.09.1998 JP 27857898
(71) Applicant: NHK SPRING CO.LTD., Yokohama-shi, Kanagawa 236-0004 (JP)
(72) Inventor: KURIHARA, Tatsuya, NHK Spring Co., Ltd., Yokohama-shi, Kanagawa 236-0004 (JP); FUKUMURA, Takeo, NHK Spring Co., Ltd., Yokohama-shi, Kanagawa 236-0004 (JP); MATSUMOTO, Hiroyuki, NHK Spring Co., Ltd., Yokohama-shi, Kanagawa 236-0004 (JP)
(74) Representative: Hale, Peter
(86) International application number: JP9905197
(87) International publication number: WO0019439

(57) **Abstract**

A coding/decoding device (10) comprises an envelope (11) and a key data storage section (12) provided in the envelope (11). The key data storage section (12) includes a plurality of magnetic elements of a low-coercivity magnetic material for generating a magnetic domain magnetized in one direction and a reverse magnetic domain magnetized in the reverse direction, and magneto-electric transducers for detecting the magnetizing direction of the magnetic domains of the magnetic elements, and stores information "0" or "1" depending on the presence of a reverse magnetic domain. The envelope (11) includes magnets (15, 16) capable of applying a magnetic field for maintaining the magnetic domain structure of the magnetic elements to the magnetic elements and a yoke (17) surrounding the magnetic elements. The magnetic elements are located in a magnetic field region (18) in the envelope (11) that is defined by the magnets (15, 16) and the yoke (17).

## Description

### Technical Field

The present invention relates to a coding/decoding device suitably used in, for example, an information processing apparatus or the like having a data coding/decoding function.

### Background Art

A conventional coding/decoding device codes or decades input data by applying electrical signals from outside the device to a key data storage section or holding key data in a nonvolatile memory of the key data storage section, in order to record the key data or secret data used for coding or decoding data. Supposing an evil-minded person illegally analyzes or alters the key data storage section of the device, however, the conventional coding/decoding device is hardly safe enough from these unfair practices.

Possibly, the key data may be illegally read or the data may be altered in a manner such that the key data storage section of the aforesaid device is electrically analyzed, the device is mechanically shaved or chemically dissolved from the outside so that the inside of the device can be observed, or the values of the supply voltage and operating frequency of the device are changed into nonstandard ones to analyze the key data storage section, for example.

Accordingly, the object of the present invention is to provide a coding/decoding device that never readily permits unfair analysis or alteration.

### Disclosure of Invention

According to this invention, the magnetizing direction of magnetic domains of magnetic elements formed of a low-coercivity magnetic material, that is, the presence of a reverse magnetic domain, is utilized as means for storing coding/decoding key data.

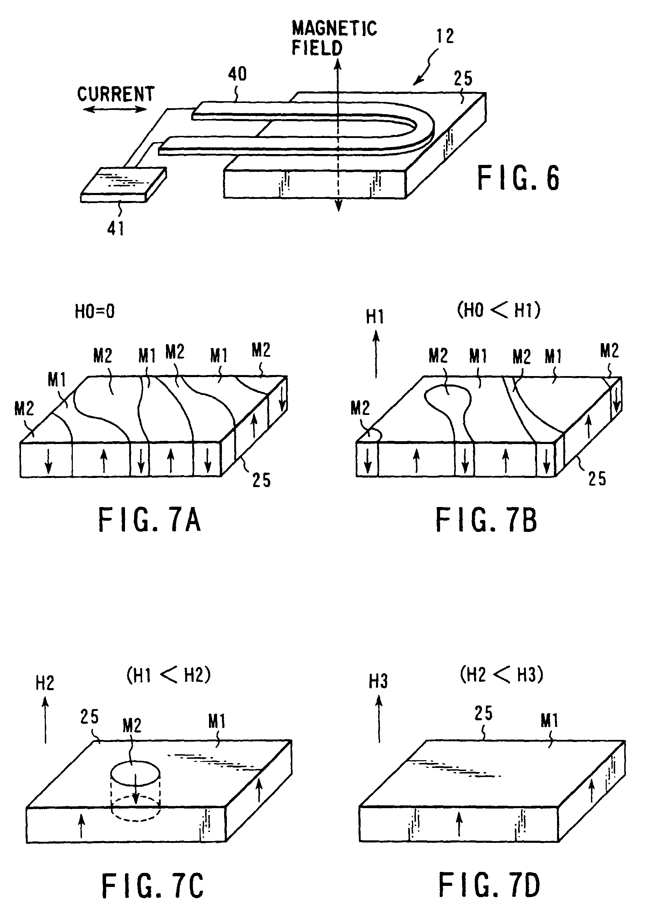

FIGS. 7A to 7D show an example of a vertically magnetized film (magnetic element 25 that magnetizes in the film thickness direction) as an example of the magnetic element that is formed of the low-coercivity magnetic material. When no external magnetic field is applied, the magnetic element 25 is divided into a plurality of magnetic domains M1 and M2 that are magnetized in different directions, as shown in FIG. 7A. This state of division or a magnetic domain structure is settled depending on the condition in which the sum total of the magnetic energy of the whole magnetic element 25 is minimized.

Thus, if the external magnetic field is gradually enhanced from the zero state (H0 = 0) shown in FIG. 7A, the area of the magnetic domains M1 that are magnetized in the same direction as the external magnetic field gradually increases, as shown in FIG. 7C for the case of the external magnetic field at H2, after going through the state of FIG. 7B in which external magnetic field is at H1. Finally, the whole magnetic element 25 turns into a single magnetic domain M1 that has the same magnetizing direction as the magnetic field at H3, as shown in FIG. 7D.

In the state of FIG. 7C immediately before the change into the single magnetic domain, the magnetic domain (reverse magnetic domain M2) that is magnetized opposite to the magnetic field H2 exists isolated. If the partial magnetic field H3 that is more intensive than H2 is applied to the region of the isolated reverse magnetic domain M2 the reverse magnetic domain M2 disappears. If this partial magnetic field H3 is removed, the reverse magnetic domain M2 is never generated in the presence of the external magnetic field H2.

If the partial magnetic field -H3 that is opposite to the aforesaid magnetic field H3 is applied to a partial region of the magnetic element 25 in this state, moreover, a reverse magnetic domain is formed there. If the partial magnetic field -H3 is removed, the reverse magnetic domain steadily exists in the presence of the external magnetic field H2. With the external magnetic field of a certain intensity applied in this manner, the formation and disappearance of the reverse magnetic domain can be controlled to maintain its magnetic domain structure.

If the aforesaid external magnetic field is removed, a magnetic domain structure such as the one shown in FIG. 7A is restored inevitably. If a more intensive external magnetic field is applied, in contrast with this, a single magnetic domain such as the one shown in FIG. 7D results. Thus, the reverse magnetic domain can be controlled to maintain its magnetic domain structure only when an external magnetic field within a certain range exists. According to the present invention, therefore, the presence of a thus controllable reverse magnetic domain is utilized as a sign "0" or "1" for the storage of secret data (key data).

A coding/decoding device of the present invention comprises an envelope and a key data storage section provided in the envelope. The key data storage section includes a magnetic element of a low-coercivity material for generating a magnetic domain structure, composed of a magnetic domain magnetized in one direction and a reverse magnetic domain magnetized in the reverse direction, and a magneto-electric transducer for detecting the magnetizing direction of the magnetic domains of the magnetic element. The envelope includes a magnet capable of applying a magnetic field for maintaining the magnetic domain structure to the magnetic element and a yoke surrounding the magnetic element, the magnetic element being located in a magnetic circuit formed of the magnet and the yoke.

The coding/decoding device of the present invention stores the information "0" or "1", depending on the presence of the reverse magnetic domain, by means of combinations of magnetic elements, which generate magnetic domains and reverse magnetic domains according to magnetic fields applied thereto, and magneto-electric transducers for detecting the magnetizing direction. By using a plurality of combinations of those magnetic elements and magneto-electric transducers, the secret data or key data as a coding or decoding key is recorded.

If an evil-minded person destroys the envelope in order to peep into the device, the intensity of the magnetic field in the envelope having so far been applied to the magnetic elements changes, and magnetic field applied to the magnetic elements also changes. Thus, the magnetic domain structure of the magnetic elements changes, and the magnetizing direction detected by the magneto-electric transducers also changes, so that the secret data (key data) having so far been stored is destroyed.

The magnetic elements used in this invention include ones that are made of a low-coercivity magnetic material (with coercive force of, e.g., about 0.1 to 500 oersteds) and have the form of a thin film or leaf that magnetizes in the film thickness direction (or undergoes vertical magnetization) or a thin film or leaf that magnetizes in the surface direction (or undergoes in-surface magnetization). Alternatively, the magnetic elements may be magnetic wires that magnetize in a uniaxial direction.

Further, this invention comprises a conduction path, located near the aforesaid magnetic element and capable of supplying current for applying a magnetic field for the generation and erasure of reverse magnetic domains to the magnetic element, and an electric circuit for controlling the current of the conduction path, the electric circuit being located in a magnetic field region in the envelope. With this arrangement, a regular device user can reload the key data during the device operation without being detected by any outsider.

The coding/decoding device of the present invention can be used in coding and decoding important information and data, and besides, it effectively functions if it is incorporated in a terminal device for varieties of information processing or communication terminal device, for example. The coding/decoding device provided for each terminal device can be also used as a device for authentication that checks the terminal device itself for authenticity by determining whether or not the coding/decoding device can carry out regular coding and decoding processes, for example.

More specifically, data issued by an authenticator (authentic authenticator) is applied to the input of the coding/decoding device, and the authenticator receives an output that is coded by using the key data (sign 0 or 1 related to the presence of the reverse magnetic domains of the magnetic elements) stored in the key data storage section. Since the authenticator is aware of the coding/decoding method (algorithm or the like) and the key data of this coding/decoding device, s/he decodes the received output data by the given coding/decoding method and compares it with the issued input data. If these two data are in conformity to each other, the terminal device that is provided with the coding/decoding device is concluded to be authentic. If the two data are nonconforming, the coding/decoding device is concluded to be inauthentic, and use of this terminal device is refused.

In the case where the device is used as the device for authentication, the key data stored in the key data storage section need not be data that is artificially written by the authenticator. Thus, the presence of random reverse magnetic domains that are accidentally formed in the magnetic elements during the manufacture of the device may be used directly as the key data. Since the key data is inartificial random data for each device, in this case, even the authenticator cannot detect the contents of the key data. Accordingly, the authenticator actually determines in advance the correspondence between the input data and the output data for each device, and the result is recorded and used as a ground for decision on the authenticity of the device.

Additional objects and advantages of the invention will be apparent from the description which follows or embodiments of the invention. Various objects and advantages of the invention may be realized by means of the arrangements and combinations evidently pointed out in the appended claims.

### Brief Description of Drawings

The accompanying drawings, which are incorporated in and constitute a part of the specification, illustrate presently preferred embodiments of the invention, and together with the general description given above and the detailed description of the preferred embodiments given below, serve to explain the principles of the invention.
FIG. 1 is a sectional view of a coding/decoding device showing a first embodiment of the invention;
FIG. 2 is a sectional view showing an envelope used in the coding/decoding device shown in FIG. 1 and a magnetic field region;
FIG. 3 is a perspective view of the coding/decoding device shown in FIG. 1;
FIG. 4 is a perspective view of a part of a key data storage section of the coding/decoding device shown in FIG. 1;
FIG. 5 is an enlarged perspective view showing a magnetic element and a magneto-electric transducer constituting the key data storage section shown in FIG. 4;
FIG. 6 is a perspective view of a magnetic element and a conduction path for writing, showing a second embodiment of the present invention;
FIG. 7A is a perspective view schematically showing the magnetic domain structure of a vertically magnetized film with no external magnetic field;
FIG. 7B is a perspective view schematically showing the magnetic domain structure of the vertically magnetized film with a scanty external magnetic field applied thereto;
FIG. 7C is a perspective view schematically showing the magnetic domain structure of the vertically magnetized film with a more intensive external magnetic field applied thereto; and
FIG. 7D is a perspective view schematically showing the magnetic domain structure of the vertically magnetized film with the maximum external magnetic field applied thereto.

### Best Mode for Carrying Out the Invention

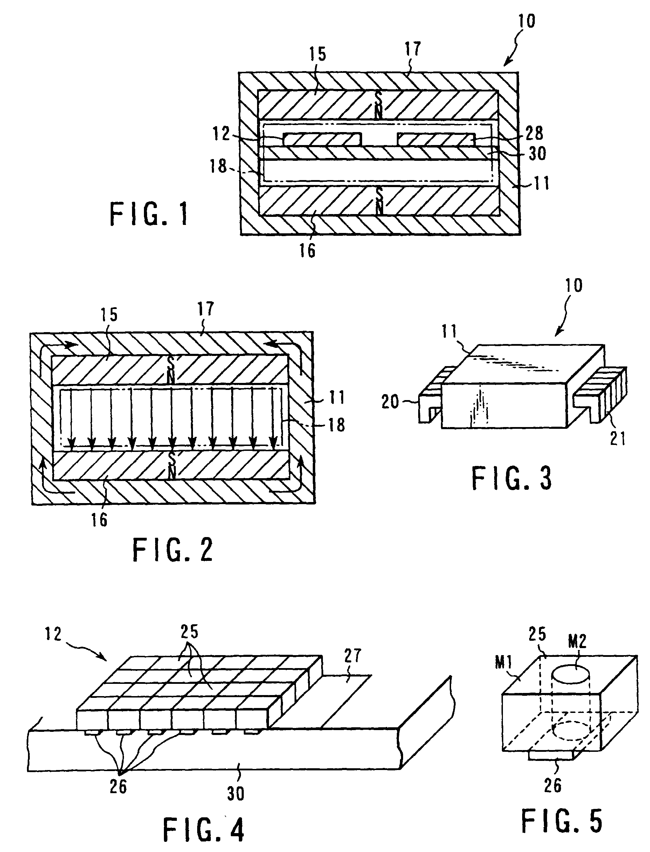

A coding/decoding device according to a first embodiment of the invention will now be described with reference to FIGS. 1 to 5.

A coding/decoding device 10 shown in FIG. 1 comprises a box-shaped envelope 11, which forms a magnetic circuit mentioned later, a key data storage section 12 provided in the envelope 11, etc.

The envelope 11 includes a pair of permanent magnets 15 and 16 of a common shape, having magnetic energies of substantially equal magnitudes, and a yoke 17 formed of a magnetic material such as Fe or Fe-Si. The magnets 15 and 16 are fixed on the inside of the yoke 17 with their magnetic poles of the same polarity (e.g., north poles) opposed to each other, and form a magnetic circuit that generates flows of magnetic fluxes (magnetic fields) diagrammatically indicated by arrows in FIG. 2. The magnetic fluxes generated from these magnets 15 and 16 apply a magnetic field of a magnitude H2 shown in FIG. 7C in a magnetic field region 18.

As shown in FIG. 3, an input terminal 20 is provided on one end side of the envelope 11, and an output terminal 21 is provided on the other end side of the envelope 11. The key data storage section 12 is stored in the aforesaid magnetic field region 18 in the envelope 11. The key data storage section 12 includes a plurality of magnetic elements 25 that are arranged like cells, as shown in FIG. 4, a magneto-electric transducers 26, such as MR elements or Hall elements, provided on one surface side of the magnetic elements 25 in order to detect the presence of a reverse magnetic domain M2 that is generated in each magnetic element 25, as shown in FIG. 5, an amplifier circuit 27 connected to electrically to the magneto-electric transducers 26, a coding/decoding processor 28 (shown in FIG. 1) etc. A circuit pattern that constitutes the amplifier circuit 27 is provided on a base 30. The coding/decoding processor 28 is provided in the magnetic field region 18 of the magnetic circuit in the envelope 11.

An example of the magnetic element 25 is in the form of a vertically magnetized film, that is, a thin film or leaf magnetized in the thickness direction, which is made of a low-coercivity magnetic material with coercive force of about 0.1 to 500 oersteds (Oe) and having a film thickness of about 0.1 to 100 µm. Suitable materials for the magnetic elements 25 include amorphous alloy films that combine rare-earth elements, such as Gd, Tb, Dy, Ho, etc., with ferrous transition metals, such as Fe, Co, etc., rare earth-iron garnet single crystal films, etc.

The magnetizing direction of the magnetic domain (i.e., presence of a reverse magnetic domain) of the magnetic element 25 is detected by means of the magneto-electric transducers 26, and is used as a sign "0" or "1" depending on the presence of a reverse magnetic domain. Thus, one-bit information is recorded by means of one set of magnetic elements 25 and magneto-electric transducers 26. A plurality of sets of magnetic elements 25 and magneto-electric transducers 26 are arranged like cells and fixed on the base 30, and secret data or key data as coding/decoding keys are held by combining a plurality of bits that are represented by means of the sets of magnetic elements 25 and magneto-electric transducers 26.

When electric data is inputted through the input terminal 20, in the coding/decoding device 10 constructed in this manner, the content of the aforesaid key data stored in the key data storage section 12 is added to the input data after it is amplified by means of the amplifier circuit 27. Then, the data is coded or decoded according to a given algorithm in the coding/decoding processor 28 and delivered from the output terminal 21.

If an evil-minded person destroys the envelope 11 in order to detect the key data stored in the coding/decoding device 10, the intensity of the magnetic field of the magnetic field region 18 between the magnets 15 and 16 changes, and the magnitude of an external magnetic field that is applied to the magnetic elements 25, that is, the magnetic circuit that holds the reverse magnetic domain of each magnetic element 25, changes. Thereupon, the magnetic domain structure of a magnetic domain M1 and the reverse magnetic domain M2 having so far been maintained changes into the magnetic domain structure shown in FIG. 7A or 7D, for example, so that the presence of the reverse magnetic domain M2 detected by the magneto-electric transducers 26 also changes. Accordingly, data on the reverse magnetic domain having so far been stored in the key data storage section 12 is destroyed, so that the key data stored in the device 10 ceases to be accessible.

In a second embodiment shown in FIG. 6, a pattern of a looped conduction path 40 for supplying current to apply a magnetic field to each magnetic element 25 is formed near the magnetic element 25, depending on the use application of the coding/decoding device. The conduction path 40 is provided for each of the magnetic elements 25. As current is supplied to those conduction paths 40 which extend along desired magnetic elements 25 among others, thereby generating magnetic fields, reverse magnetic domains can be generated in or erased from the desired magnetic elements 25. For other details of arrangement and operation, the device of this embodiment is similar to the coding/decoding device 10 of the first embodiment, so that common numerals are used to designate portions that are common to the two devices, and a description of those portions is omitted.

In the case of this embodiment (FIG. 6), an electric circuit 41 for controlling the current of the conduction path 40 is provided in the magnetic circuit that includes the magnetic field region 18 inside the aforesaid envelope 11, so that the key data can be reloaded in the middle of device operation without being detected by any outsider who is not a regular user.

According to the individual embodiments described above, the magnetic element 25 for magnetization in the film thickness direction is used as an example of a magnetic element. In carrying out the invention, however, the magnetic element may be a thin film or leaf (e.g., several µm to 300 µm in thickness) of a magnetic material that undergoes in-surface magnetization (or magnetizes in the surface direction). An Fe-B-Si amorphous alloy, Fe-Ni, or Fe-Si is a suitable material for the magnetic element. Alternatively, a wire-shaped magnetic element (magnetic wire) that magnetizes in a uniaxial direction may be used instead. An example of the magnetic wire is formed of a magnetic material, such as an Fe-B-Si amorphous alloy, Fe-Ni, or Fe-Si, and has coercive force of, for example, about 0.1 to 700 oersteds and a wire diameter of about ⌀10 µm to ⌀200 µm.

Although the envelope 11 for forming the magnetic circuit is not limited to the foregoing embodiments, the magnets 15 and 16 should be arranged so as to apply a magnetic field in a direction such that the magnetic elements magnetize. In the case where the magnetic elements 25 that magnetize in the film thickness direction are used, as in the first embodiment, for example, it is necessary only that the magnets 15 and 16 be arranged so as to apply the magnetic field in the thickness direction of the magnetic elements 25 when the magnetic circuit of the envelope 11 is destroyed. In the case of the magnetic element that magnetizes in the surface direction, it is necessary only that the magnets be located so as to apply magnetism in the surface direction of the magnetic element when the magnetic circuit is destroyed. In the case of the wire-shaped magnetic element that magnetizes in the uniaxial direction, it is necessary only that the magnets be located so as to apply magnetism in the axial direction of the magnetic element when the magnetic circuit is destroyed. The magnets that constitute the magnetic circuit may be one or two or more in number. In short, it is necessary only that the magnetic field region for maintaining the aforesaid magnetic domain structure in the envelope be able to be formed.

The magnets 15 and 16 may be replaced with a solenoid coil (electromagnet) that generates a magnetic field as it is supplied with current. In this case, the intensity of the magnetic field is set at a level about 0.2 to 3 times as high as the coercive force of the magnetic element 25. If the magnetic properties of the magnets 15 and 16 and the yoke 17 are subjected to a measure of variation for each individual coding/decoding device 10, moreover, the randomness of the magnetic domain structure of the magnetic elements that is obtained during the manufacture of the coding/decoding device 10 can be enhanced.

In the coding/decoding device of the present invention, the key data based on the magnetic domain structure (presence of a reverse magnetic domain) of the magnetic elements is stored in the key data storage section in the envelope, so that the key data can be prevented from being illegally read through electrical analysis or measurement. Further, the magnetic circuit that generates the magnetic field for holding the key data is composed of the envelope that constitutes the shell of the coding/decoding device, and the magnetic elements are located in the magnetic field region in the envelope. Therefore, the magnetic field that is applied to the magnetic elements when the envelope is destroyed by mechanical or chemical treatment changes, and the magnetic domain structure changes, so that the contents of the key data are also destroyed.

For these reasons, it is hard unduly to analyze or alter the coding/decoding devices, and wrongful use of an apparatus that utilizes these devices can be prevented. Since the key data storage section is provided inside the yoke of the envelope that forms a box-shaped closed space, moreover, illegal access to the inside of the devices can be made more difficult, and bad influences of disturbed magnetic fields can be attenuated.

### Industrial Applicability

As seen from the above description, the coding/decoding device of the present invention is applicable to an information processing apparatus having, for example, a coding/decoding function for data, and the like.

Additional advantages and modifications will readily occur to those skilled in the art. Therefore, the invention in its broader aspects is not limited to the specific details and representative embodiments shown and described herein. Accordingly, various modifications may be made without departing from the spirit or scope of the general inventive concept as defined by the appended claims and their equivalents.

## Claims

1. A coding/decoding device comprising:
a key data storage section including a magnetic element of a low-coercivity material for generating a magnetic domain structure, composed of a magnetic domain magnetized in one direction and a reverse magnetic domain magnetized in the reverse direction, and a magneto-electric transducer for detecting the magnetizing direction of the magnetic domains of the said magnetic element; and
an envelope for storing said key data storage section, said envelope including a magnet capable of applying a magnetic field for maintaining the magnetic domain structure to said magnetic element and a yoke surrounding said magnetic element, said magnetic element being located in a magnetic circuit formed of said magnet and the yoke.

2. A coding/decoding device according to claim 1, wherein said magnetic element has the form of a thin film or leaf capable of magnetization in the thickness direction thereof.

3. A coding/decoding device according to claim 1, wherein said magnetic element has the form of a thin film or leaf capable of magnetization in the surface direction thereof.

4. A coding/decoding device according to claim 1, wherein said magnetic element is a magnetic wire capable of magnetization in a uniaxial direction.

5. A coding/decoding device according to claim 1, which further comprises a conduction path, located near said magnetic element and capable of supplying current for applying a magnetic field to said magnetic element, and an electric circuit for controlling the current of the conduction path, the electric circuit being located in a magnetic field region in said envelope.
